# EUROPEAN PATENT APPLICATION

(11) **EP 2 505 687 A1**
(43) Date of publication of application: **03.10.2012**
(21) Application number: 10834490.4
(22) Date of filing: 19.11.2010
(51) Int. Cl.: C23C 16/44, C23C 14/00, H01L 21/31

(54) **CLEANING GAS**

(30) Priority: 01.12.2009 JP 2009273030
(71) Applicant: Central Glass Company, Limited, Yamaguchi 755-0001 (JP)
(72) Inventor: TAKADA, Naoto, Saitama 350-151 (JP); MORI, Isamu, Tokyo 101-0054 (JP)
(74) Representative: Manitz, Gerhart
(86) International application number: PCT/JP2010/070655
(87) International publication number: WO 2011/068038

(57) **Abstract**

Disclosed is a cleaning gas for deposits, which contains CHF₂COF. The cleaning gas may contain O₂, O₃, CO, CO₂, F₂, NF₃, Cl₂, Br₂, I₂, XFₙ (In this formula, X represents Cl, I or Br. n represents an integer satisfying 1≤n≤7.), CH₄, CH₃F, CH₂F₂, CHF₃, N₂, He, Ar, Ne, Kr and the like, and can be applied to deposits that include W, Ti, Mo, Re, Ge, P, Si, V, Nb, Ta, Se, Te, Mo, Re, Os, Ir, Sb, Ge, Au, Ag, As, Cr, their compounds, and the like. This cleaning gas is not only excellent in cleaning performances but also easily available and does not substantially by-produce CF₄ that places a burden on the environment.

## Description

### TECHNICAL FIELD

The present invention relates to a cleaning gas for removing undesired deposits deposited on an inner wall of an apparatus, a jig, a piping or the like by means of chemical vapor deposition (CVD method), metal organic chemical vapor deposition (MOCVD method), sputtering method, sol-gel method, vapor deposition method or the like at the time of producing thin films, thick films, powders, whiskers or the like.

### BACKGROUND OF THE INVENTION

In processes for producing semiconductor thin film devices, optical devices and super steel materials, there have been produced various thin films, thick films, powders and whiskers by means of CVD method, sputtering method, sol-gel method, vapor deposition method and the like. At the time of production, deposits are formed on locations on which films, whiskers and powders should not be deposited, for example on an inner wall of a reactor, a jig for holding a work, and the like. Formation of such undesired deposits can result in occurrence of particles to make it difficult to produce good films, powders and whiskers and hence it becomes necessary to remove the deposits at any time.

In order to remove such undesired deposits, cleaning gases containing perfluorocarbons (PFCs) such as CF₄, C₂F₆, C₃F₈ and the like have been used conventionally. However, these gases exist in the environment stably for a long period of time and therefore regarded as having high global warming potentials, so that their adverse influence on the environment has come to an issue. According to the IPCC Fourth Assessment Report, their GWP are as follows (on a 100 year scale).
CF₄: 7390
C₂F₆: 12200
C₃F₈: 8830

A cleaning gas partially having the structure of CF₃ group e.g. C₂F₆, C₃F₈ and the like generates active species exemplified by CF₃ radicals, ions and the like in a deposition room (a chamber) thereby exhibiting the cleaning effect; however, CF₃ active species are brought into contact with fluorine radicals or with fluorine active species of ions to be recombined thereto, thereby forming CF₄ as a by-product. Guidelines on the destruction of PFCs issued by Office of Fluorocarbons Control Policy, Global Environmental Issues Division of the Global Environment Bureau of the Ministry of the Environment (issued in March 2009) states that CF₄ is the most undecomposable PFC in the environment and therefore it may not be sufficiently destructed under the destructing conditions similar to those for other fluorocarbons.

As a fluorine-containing cleaning gas having low global warming potentials and substitutable for PFCs, there have been proposed COF₂, CHF₂OF (Patent Publication 1), CF₃COF (Patent Publications 2 and 3) and the like. These publications state it is possible to reduce by-production of CF₄, for example, by optimizing an etching condition for CF₃COF.

### REFERENCES ABOUT PRIOR ART

### Patent Publication

Patent Publication 1: Japanese Patent Application Publication No. 2000-63826
Patent Publication 2: Japanese Patent Application Publication No. 2000-265275
Patent Publication 3: Japanese Patent Application Publication No. 2002-158181

### SUMMARY OF THE INVENTION

As mentioned above, in Patent Publications 1 and 2, it is stated that by-production of CF₄ can be reduced by optimizing a cleaning condition for CF₃COF. In other words, the cleaning condition exemplified by the ratio between CF₃COF and oxygen and the like is restricted by not the cleaning performances but the rate of CF₄ by-production. In fact, there is expected a case difficult to constantly reduce by-production of CF₄ under restricted conditions such as the configuration or corrosion resistance of a chamber, a desired cleaning rate and the like.

Under a strict condition, i.e., with a cleaning gas having high temperatures and concentrations, the by-produced CF₄ is generally decomposed again, so that by-production of CF₄ is sometimes not recognized from appearance. However, if cleaning is performed under a milder condition restricted by the corrosion resistance of the apparatus, by-production of CF₄ may occur. It is therefore not possible to fundamentally avoid a recombination of the CF₃ active species and the fluorine active species so long as the cleaning gas partially having the structure of CF₃ group is used.

Though there is a case of using COF₂ or CF₃COF also proposed as a cleaning gas having low global warming potentials and substitutable for PFC, a hazardous gas including CO or F₂ is to serve as a starting material. Accordingly, an expensive high corrosion-resistant manufacturing facility is needed.

In view of the above, an object of the present invention is to provide a novel cleaning gas which is not only excellent in cleaning performances but also easily available and does not substantially by-produce CF₄ that places a burden on the environment.

The present inventors had eagerly made studies and thereby found that the above-mentioned object can be entirely attained by using difluoroacetyl fluoride (CHF₂COF), with which the present invention has come to completion.

More specifically, the present invention is as follows.

### [Invention 1]

A cleaning gas for removing deposits collaterally deposited on an inner wall of a fabrication apparatus or on an accessory apparatus thereof at the time of producing thin films, thick films, powders or whiskers by means of chemical vapor deposition (CVD method), metal organic chemical vapor deposition (MOCVD method), sputtering method, sol-gel method or vapor deposition method, the cleaning gas containing CHF₂COF.

### [Invention 2]

A cleaning gas of Invention 1, wherein the deposits are deposits deposited on a film-formation apparatus.

### [Invention 3]

A cleaning gas of Invention 1 or 2, wherein the deposits are deposits including W, Ti, Mo, Re, Ge, P, Si, V, Nb, Ta, Se, Te, Mo, Re, Os, Ir, Sb, Ge, Au, Ag, As, Cr and their compounds.

### [Invention 4]

A cleaning gas of Inventions 1 to 3, wherein the deposits are silicon-containing accretions.

### [Invention 5]

A cleaning gas of Inventions 1 to 4, wherein the cleaning gas contains at least one kind of gas selected from O₂, O₃, CO, CO₂, F₂, NF₃, Cl₂, Br₂, I₂, XFₙ (In this formula, X represents Cl, I or Br. n represents an integer satisfying 1≤n≤7.), CH₄, CH₃F, CH₂F₂, CHF₃, N₂, He, Ar, Ne and Kr, as an additive.

### [Invention 6]

A cleaning gas of Inventions 1 to 5, wherein the cleaning gas contains at least CHF₂COF and O₂.

### [Invention 7]

A cleaning gas of Inventions 1 to 6, wherein the cleaning gas contains at least CHF₂COF, O₂ and CO.

### [Invention 8]

A method for removing deposits, using a cleaning gas of Inventions 5 to 7.

### [Invention 9]

A method for removing deposits, of Invention 8, wherein the deposits are deposits deposited on a film-formation apparatus.

### [Invention 10]

A method for removing deposits, of Invention 8 or 9, wherein the deposits are deposits including W, Ti, Mo, Re, Ge, P, Si, V, Nb, Ta, Se, Te, Mo, Re, Os, Ir, Sb, Ge, Au, Ag, As, Cr and their compounds.

### [Invention 11]

A method for removing deposits, of Inventions 8 to 10, wherein the deposits are silicon-containing accretions.

### [Invention 12]

A method for removing deposits, using a cleaning gas of Inventions 5 to 7 upon activating it by high frequencies or microwaves of remote plasma.

### BRIEF EXPLANATION OF THE DRAWINGS

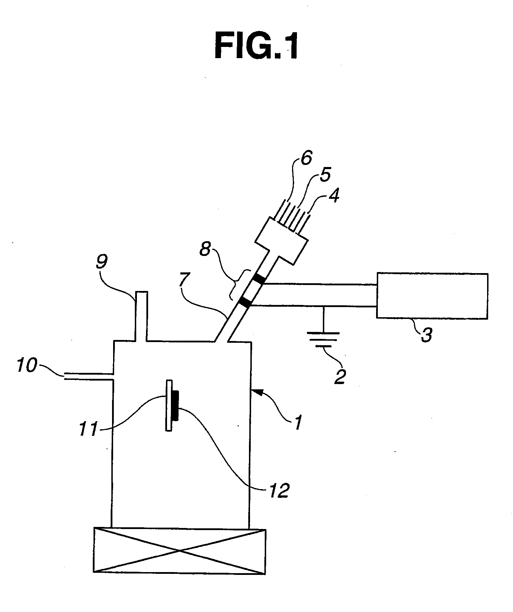

[Fig. 1] A schematic view of a remote plasma apparatus used in Examples and Comparative Examples.

### DETAILED DESCRIPTION

The cleaning gas according to the present invention is not only characterized by placing a slight burden on the environment by virtue of its containing CHF₂COF but also exhibits the effect of good cleaning performances in semiconductor thin film-forming apparatus, i.e., the effect of high etching rates, the effect of not bringing corrosion to the apparatus and the like. Additionally, a cleaning method using the cleaning gas provides the similarly excellent cleaning performances. Hence the cleaning gas of the present invention is useful for removing deposits formed on the thin film-forming apparatus applying CDV method or the like.

The present invention will be hereinafter discussed in detail.
CHF₂COF can be readily and rationally synthesized by catalytic cracking of 1-alkoxy-1,1,2,2-tetrafluoroethane represented by CHF₂CF₂OR (where R is an alkyl group including Me, Et, n-Pr, iso-Pr, n-Bu, sec-Bu, iso-Bu, tert-Bu and the like) and used as a cleaning agent, a foaming agent or the like such as HFE-254pc (CHF₂CF₂OMe), HFE-374pc-f (CHF₂CF₂OEt) and the like. Moreover, HFE-254pc and HFE-374pc-f can be synthesized by adding methanol or ethanol to an industrially mass-produced tetrafluoroethylene so as to be greatly available compounds.

CHF₂COF has a boiling point of 0°C and therefore serves as a highly convenient cleaning gas that can be handled as either liquid or gas. Additionally, CHF₂COF is reacted with water to be decomposed into difluoroacetic acid (CHF₂COOH) and hydrogen fluoride (HF), so that usually its hazard can be eliminated by using a water scrubber. It is also preferable to use an alkaline water scrubber. Even in the event of passing the hazard-eliminating step so as to be emitted into the air, CHF₂COF is reacted with rain and steam in the air thereby being readily decomposed. Thus its environmental impact is extremely minimal.

As a point where CHF₂COF of the present invention is significantly different from the existing CF₃COF in property, it is possible to cite an easiness to establish a ketene structure. CHF₂COF is known to be able to take on a ketene structure represented by CF₂=C=O as shown in the following equation. In the case of CF₃COF, a reaction for taking on the ketene structure is an endothermic reaction calculated at 165.9 kcal. In order to develop this reaction a further activation energy is required in addition to the above free energy, so that the likelihood of this reaction can be said to be actually remarkably little.

CHF₂COF → CF₂=C=O + HF + 48.9 kcal/mol

CF₃COF → CF₂=C=O + F₂ + 165.9 kcal/mol

The heat of reaction is a value calculated by B3LYP/6-311G+**.

As will be discussed in Examples, in the cases of using CHF₂COF as the cleaning gas, CF₄ was not detected at all even under variously modified conditions. It can be supposed from this fact that cleaning was developed through a vastly different mechanism from CF₃COF.

Furthermore, in the case of using CF₃COF, once generated CF₃ active species are brought into contact with fluorine active species with a certain probability to cause recombination thereby by-producing CF₄ (in a cleaning process employing plasma, for example). On the contrary, in the case of using CHF₂COF, by-production remains at CHF₃ which is relatively reasonably decomposable even if CHF₂ active species and fluorine active species are brought into contact with each other. Stochastically there is the possibility that CHF₃ is so decomposed as to form CF₃ active species and it is bonded to the fluorine active species again thereby to by-produce CF₄; however, it is easily supposed that such a probability is extremely small as compared to cleaning gases partially having the structure of CF₃ group (CF₃COF, etc.). For the above reasons CHF₂COF is considered not to substantially by-produce CF₄. As a matter of fact, by-production of CF₄ was not recognized in any of the Examples.

Deposits at which the cleaning gas of the present invention aims are undesired deposits collaterally deposited at the time of producing thin films, thick films, powders, whiskers or the like by means of chemical vapor deposition (CVD method), metal organic chemical vapor deposition (MOCVD method), sputtering method, sol-gel method, vapor deposition method or the like on an inner wall of the fabrication apparatus or on an accessory apparatus such as a jig, a piping or the like. In this specification, "a deposit(s)" refers to the above-mentioned "undesired deposit(s)" unless otherwise specified.

As deposits that can be cleaned by the cleaning gas of the present invention, it is possible to cite W, Ti, Mo, Re, Ge, P, Si, V, Nb, Ta, Se, Te, Mo, Re, Os, Ir, Sb, Ge, Au, Ag, As, Cr, Hf, Zr, Ni, Co and their compounds, and more specifically, it is possible to cite oxides, nitrides, carbides and borides such as SiO₂ WSiₓ, TiN, Ta₂O₅, Si₃N₄, SiB and the like and their composites. Among these, W, WSiₓ, Ti, TiN, Ta₂O₅ Mo, Re, Ge, Si₃N₄, Si, SiO₂ and the like are preferable. In particular, a deposit containing at least silicon or a compound thereof, i.e, a silicon-containing deposit, is preferable as the target to remove.

In consideration of the kind and thickness of the deposits to be removed and the kind of the material used for an apparatus for forming thin film or the like, the cleaning gas according to the present invention allows an addition of any of additives including O₂, O₃, CO, CO, F₂, NF₃, Cl₂, Br₂, I₂, XFₙ (In this formula, X represents Cl, I or Br. n represents an integer satisfying 1≤n≤7. Concrete examples are ClF, ClF₃, BrF, BrF₃, IF₅ and IF₇.), CH₄, CH₃F, CH₂F₂, CHF₃, N₂, He, Ar, Ne and Kr. The addition of oxygen is effective at improving the cleaning rate. More specifically, the mole ratio represented by CHF₂COF:O₂ is preferably from 10:1 to 1:5, more preferably from 5:1 to 1:3. Furthermore, in the case of adding a further additive other than oxygen, an addition exceeding the above range is also acceptable. Though the range depends on the amount of a hydrogen-containing additive such as CH₄ and the like, it is preferable that the mole ratio represented by CHF₂COF:O2 is around 20:1 to 1:20.

A preferable combination is O₂ and a compound having a carbon number of 1 (CO, CO₂, CH₄, CH₃F, CH₂F₂, CHF₃). Particularly, an addition of O₂ and CO is preferable. CO traps HF (which has been by-produced, for example when ketene is generated) in the form of HCOF and works as a cleaning agent in itself, so as to be efficiently used. The amount of CO to be added is from 10:1 to 1:5, preferably from 5:1 to 1:1 in a mole ratio represented by CHF₂COF:CO. An inert gas exemplified by N₂, He, Ne, Ar, Kr, Xe and the like not only exhibits the dilution effect but also, concerning Ar in particular, effective at stabilizing plasma; therefore, it improves the cleaning rate by a synergistic effect with CHF₂COF. The addition of F₂, NF₃, Cl₂, Br₂, I₂, XFₙ (X=Cl, I, Br, 1≤n≤7), CH₄, CH₃F, CH₂F₂ or CHF₃ is effective at controlling the cleaning rate depending on the kind of deposits to be removed.

The reaction conditions are suitably selected with consideration given to the material of the apparatus to be treated, and not particularly limited. However, the temperature is preferably not higher than 800°C in the case where the material of the apparatus is quartz, while it is preferably not higher than 500°C in the case where ceramics or a metal such as aluminum is partially or entirely used as the material. Temperatures higher than the above ones bring about corrosion so as not to be preferable. Then, the pressure at temperatures exceeding 500°C is preferably not larger than 13.3 kPa (100 Torr) and more preferably not larger than 6.6 kPa (50 Torr). Pressures exceeding 100 Torr bring about corrosion so as not to be preferable.

Cleaning performed through the use of the cleaning gas of the present invention can apply any of thermal decomposition method, photodecomposition method and plasma method, particularly preferably the plasma method. The plasma method may be one that generates plasma in a chamber by using high frequencies or microwaves, but the preferably employed one is a remote plasma method that generates plasma outside a chamber and then introduces the plasma into the chamber. As an apparatus to be treated with the cleaning gas of the present invention, it is possible to apply a film-formation apparatus for forming thin films for semiconductor devices, liquid crystal display devices, optical devices, coating tools and the like by CVD method, or a fabrication apparatus for producing whiskers, powders and the like by CVD method. Among them, application to the film-formation apparatus is particularly preferable, and application to a film-formation apparatus using a silicon compound for semiconductor devices, liquid crystal display devices and the like is more preferable.

### EXAMPLES

The present invention will be more readily understood with reference to the following Examples.

### [Examples 1 to 4 and Comparative Examples 1 to 5]

A schematic view of an apparatus used for an experiment was shown in Fig. 1. By using a high-frequency source 3 (13.56 MHz, 50 W), gas specimens (difluoroacetyl fluoride (CHF₂COF), oxygen (O₂), carbon monoxide (CO)) having been supplied from a gas inlet at flow rates shown in Table 1 were excited in a sapphire tube 7 attached to the top of a reaction chamber 1 thereby generating active species. The active species were supplied into the chamber by the flow of gas, upon which etching was conducted on a sample 12 (a silicon-substrate doped with phosphorous) fixed by a sample holder 11.

Among the gas specimens, CHF₂COF, CF₃COF, CF₄ and C₂F₆ were introduced from a first gas inlet 4, O₂ was introduced from a second gas inlet 5, and CO was introduced from a third gas inlet 6, through a mass flow controller (though not shown). The temperature of the substrate (or the sample holder 11) was set at 25°C and the pressure was set at 13.3 Pa (0.1 Torr). A discharged gas was diluted with nitrogen supplied at 2 L/min on a discharge side of a mechanical booster pump, and then the concentration of CF₄ was quantified by calibration curve method with the use of FT-IR.

Though the interior of the apparatus was checked upon completion of Examples 1 to 4, corrosion and the like were not found. For comparison with CHF₂COF, the etching rates in the cases of the existing cleaning gases (CF₃COF, CF₄ and C₂F₆) were measured also and referred to as Comparative Examples. Results of the above are shown in Table 1. Incidentally, "ND" shown in the Table refers to less than the floor limit for detection. The etching rate was determined in such a manner as to divide film thicknesses obtained before and after etching by an etching time.

**[Table 1]**

| | First Kind of Gas | | Second Kind of Gas | | Third kind of Gas | | Pressure | Etching Rate | CH₄ Concentration m Discharged Gas |
|---|---|---|---|---|---|---|---|---|---|
| | | Flow Rate | | Flow Rate | | Flow Rate | | | |
| | | SCCM | | SCCM | | SCCM | Torr | nm/min | volume% |
| Example 1 | CHF₂COF | 50 | O₂ | 21.4 | None | - | 0.1 | 737.9 | ND |
| Example 2 | CHF₂COF | 50 | O₂ | 33.3 | None | - | 0.1 | 768.8 | ND |
| Example 3 | CHF₂COF | 50 | O₂ | 50 | None | - | 0.1 | 724.7 | ND |
| Example 4 | CHF₂COF | 50 | O₂ | 50 | CO | 25 | 0.1 | 1024.1 | ND |
| Comparative Example 1 | CF₃COF | 50 | O₂ | 21.4 | None | - | 0.1 | 778.9 | 0.089 |
| Comparative Example 2 | CF₃COF | 50 | O₂ | 33.3 | None | - | 0.1 | 824.3 | 0.23 |
| Comparative Example 3 | CF₃COF | 50 | O₂ | 50 | None | - | 0.1 | 789.4 | 0.31 |
| Comparative Example 4 | CF₄ | 50 | O2 | 21.4 | None | - | 0.1 | 22.8 | 0.84 |
| Comparative Example 5 | C₂F₆ | 50 | O₂ | 21.4 | None | - | 0.1 | 48.6 | 0.76 |

| | | | | | | | | | |
|---|---|---|---|---|---|---|---|---|---|
| CHF₂COF: Difluoroacetyl fluoride CF₃COF: Trifluoroacetyl fluoride O₂: Oxygen CO: Carbon monoxide CF₄: Carbon tetrafluoride C₂F₆: Hexafluoroethane | | | | | | | | | |

### EXPLANATION OF REFERENCE NUMERALS

- 1: Chamber
- 2: Earth
- 3: High-frequency source
- 4: First gas inlet
- 5: Second gas inlet
- 6: Third gas inlet
- 7: Sapphire tube
- 8: Induction coil
- 9: Electronic pressure meter
- 10: Discharged-gas line
- 11: Sample holder
- 12: Sample

## Claims

1. A cleaning gas for removing deposits collaterally deposited on an inner wall of a fabrication apparatus or on an accessory apparatus thereof at the time of producing thin films, thick films, powders or whiskers by means of chemical vapor deposition (CVD method), metal organic chemical vapor deposition (MOCVD method), sputtering method, sol-gel method or vapor deposition method, the cleaning gas containing CHF₂COF.

2. A cleaning gas as claimed in Claim 1, wherein the deposits are deposits deposited on a film-formation apparatus.

3. A cleaning gas as claimed in Claim 1 or 2, wherein the deposits are deposits including W, Ti, Mo, Re, Ge, P, Si, V, Nb, Ta, Se, Te, Mo, Re, Os, Ir, Sb, Ge, Au, Ag, As, Cr, Hf, Zr, Ni, Co and their compounds.

4. A cleaning gas as claimed in any one of Claims 1 to 3, wherein the deposits are silicon-containing accretions.

5. A cleaning gas as claimed in any one of Claims 1 to 4, wherein the cleaning gas contains at least one kind of gas selected from O₂, O₃, CO, CO₂, F₂, NF₃, Cl₂, Br₂, I₂, XFₙ (In this formula, X represents Cl, I or Br. n represents an integer satisfying 1≤n≤7.), CH₄, CH₃F, CH₂F₂, CHF₃, N₂, He, Ar, Ne and Kr, as an additive.

6. A cleaning gas as claimed in any one of Claims 1 to 5, wherein the cleaning gas contains at least CHF₂COF and 0₂.

7. A cleaning gas as claimed in any one of Claims 1 to 6, wherein the cleaning gas contains at least CHF₂COF, O₂ and CO.

8. A method for removing deposits, using a cleaning gas as claimed in any one of Claims 5 to 7.

9. A method for removing deposits, as claimed in Claim 8, wherein the deposits are deposits deposited on a film-formation apparatus.

10. A method for removing deposits, as claimed in Claim 8 or 9, wherein the deposits are deposits including W, Ti, Mo, Re, Ge, P, Si, V, Nb, Ta, Se, Te, Mo, Re, Os, Ir, Sb, Ge, Au, Ag, As, Cr and their compounds.

11. A method for removing deposits, as claimed in Claims 8 to 10, wherein the deposits are silicon-containing accretions.

12. A method for removing deposits, using a cleaning gas as claimed in any one of Claims 5 to 7 upon activating it by high frequencies or microwaves of remote plasma.
